Europäisches Patentamt

European Patent Office

Office européen des brevets

(19)

(11) Publication number: **0 060 205**
**B1**

# EUROPEAN PATENT SPECIFICATION

(12)

(45) Date of publication of patent specification: **15.10.86**

(51) Int. Cl.⁴: **H 01 L 21/76, H 01 L 23/28**

(21) Application number: **82400448.5**

(22) Date of filing: **12.03.82**

(54) **Low temperature melting binary glasses for leveling surfaces of integrated circuits containing isolation grooves.**

(30) Priority: **16.03.81 US 243987**

(43) Date of publication of application:
**15.09.82 Bulletin 82/37**

(45) Publication of the grant of the patent:
**15.10.86 Bulletin 86/42**

(84) Designated Contracting States:
**DE FR GB IT NL**

(56) References cited:
**GB-A-1 461 943**

**Patent Abstracts of Japan Vol. 2, No. 147, 8 December 1978 page 9241E78**

**IBM TECHNICAL DISCLOSURE BULLETIN Vol. 19, No. 11, april 1977, New York P.C. LI et al. "Preparation of High Temperature Phosphosilicate Glass" page 4155**

(73) Proprietor: **FAIRCHILD CAMERA & INSTRUMENT CORPORATION**
**464 Ellis Street**
**Mountain View California 94042 (US)**

(72) Inventor: **Lehrer, William I.**
**1161 Seena Avenue**
**Los Altos California 94022 (US)**
Inventor: **Pierce, John M.**
**33322 Middlefield Road**
**Palo Alto California 94306 (US)**

(74) Representative: **Chareyron, Lucien et al**
**Schlumberger Limited Service Brevets c/o Giers**
**12, place des Etats Unis B.P. 121**
**F-92124 Montrouge Cédex (FR)**

Courier Press, Leamington Spa, England.

## Description

### Background of the Invention
*Field of the Invention*

This invention relates to integrated circuits fabricated using glass isolation techniques and in particular to an integrated circuit fabricated using such techniques wherein the surface of the glass formed in the isolation grooves is substantially flat.

*Description of the Prior Art*

The use of oxide for isolating islands of semiconductor material in which are formed active devices is well-known. Thus, United States Patent No. 3,648,125 on an invention of Peltzer discloses the basic oxide isolation technique now commonly employed in the manufacture of high density fast integrated circuits. This patent discloses a method of forming an isolated semiconductor structure comprising: forming active devices or selected components in to-be-formed islands of semiconductor material, each island being separated from adjacent islands by an annular shaped band of semiconductor material in which are formed no active devices or selected components, said active devices or selected components being formed by placing selected dopants in said to-be-formed islands to form selectively doped regions in said islands; etching grooves in the surface of the semiconductor material so as to remove a portion of each annular shaped band in which no active devices were formed, thereby to create a plurality of islands of semiconductor material, each island containing active devices or selected components; and oxidizing the semiconductor material exposed by said grooves to form an oxide layer of selected thickness over the surface of said grooves:

Two problems with prior art oxide isolated structures of the types disclosed in the 3 684 125 patent are 1) the grown oxide encroaches into the active regions of the devices, and 2) the interconnection of the active devices becomes more difficult due to surface irregularities in the isolating oxide. Thus in the standard oxide isolation technique wherein a groove is formed in epitaxial silicon and the resulting exposed silicon is oxidized, a "bird-beak" is well-known to form at the intersection between the semiconductor material in which active devices are to be formed and the oxide isolation regions. While in most oxide isolated semiconductor devices manufactured prior to the filing date of this specification, this bird-beak is not an insurmountable problem, as the active devices become smaller, this bird-beak becomes a greater hindrance to the achievement of high yields.

British patent GB—A—1 461 943 discloses depositing a passivating glass which softens at below 1,000°C and which has high levels (20—30%) of phosphorous in the glass. This causes the glass to leach out in the presence of water vapor. Japanese Abstract Vol. 2, No. 147, 8 December 1978, page 9241 E78 and JP—53—114355 teach another technique in which the formation of a glass layer is followed by doping the top of the layer with germanium to lower its melting temperature.

### Summary of the Invention

It is a general object of this invention to provide an improved method and structure for isolating islands of semiconductor in which active devices are formed.

This and other objects are attained in accordance with one aspect of the invention, by the method of forming an isolated semiconductor structure according to claim 1.

Another aspect of the invention includes an integrated circuit structure according to claim 10.

### Description of the Drawings

Figures 1a through 1e show cross-sectional views of a semiconductor wafer at sequential steps in the process of this invention.

Figure 2 shows in cross-section an integrated circuit structure, including interconnects on the top surface of the structure, manufactured in accordance with this invention.

### Detailed Description of the Invention

While this invention will be described in conjunction with the drawings, it should be understood that this invention can be employed in structures other than those shown for illustrative purposes in the drawings. Thus, this description is illustrative only and is not intended to limit the scope of the invention.

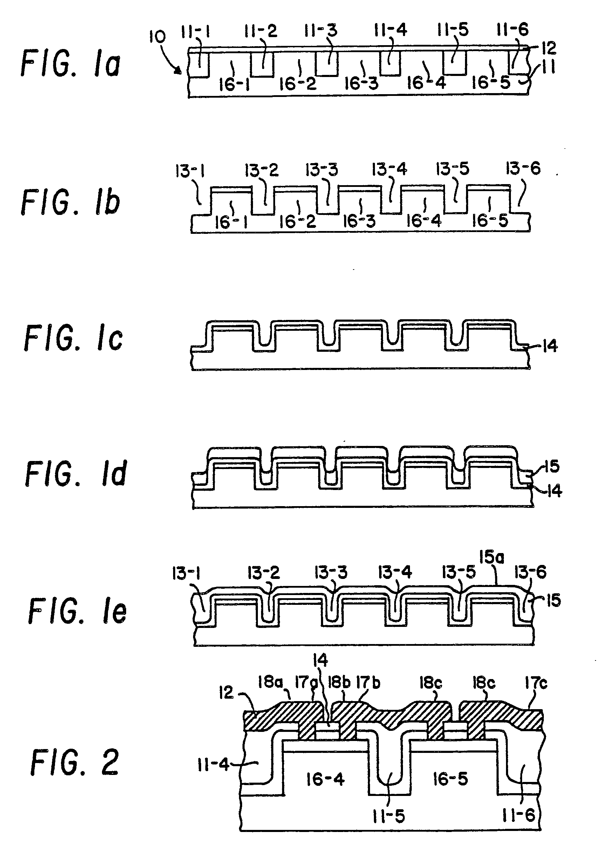

As shown in Figure 1a, semiconductor wafer 10 comprises a semiconductor substrate 11 (only a portion of which is shown for illustrative purposes only) on which has been formed a layer of oxide 12 over the top surface of the wafer. Prior to the formation of oxide 12, wafer 10 has been subjected to the standard processing techniques for the formation of active devices within the semiconductor material 11. These devices typically comprise emitter, collector and base regions of bipolar transistors if the structure represents a bipolar device or comprise source, drain and channel regions if the structure comprises an MOS device. The principles of this invention are equally applicable to MOS and bipolar processing techniques and thus the description is not intended to limit the invention to use with one or the other of these types of devices.

The active devices are formed in the surface of substrate 11 in the to-be-formed islands 16—1 through 16—5 of semiconductor material leaving regions 11—1 through 11—6 between the to-be-formed islands of semiconductor material. No active devices are to be formed in regions 11—1 through 11—6 shown in cross-section in Figure 1a. It should be understood that a typical island, such as island 16—2, in which active devices have been formed, is surrounded on all sides by regions such as regions 11—1 through 11—6 as shown in cross-section in Figure 1a so as to be laterally isolated from the adjacent to-be-formed islands 16 of semiconductor material. The five islands 16—1 through 16—5 are merely five of a plurality of such islands formed in a given device and thus are merely illustrative as to number and not limiting.

Following the fabrication of the active devices in the to-be-formed islands 16 of semiconductor material, grooves are etched between the islands using standard silicon etching techniques. Typically, the grooves are formed to a depth of approximately 1—2 microns using an acid or plasma etch well-known in the semiconductor arts. For wet etching of silicon a nitride mask of a type well-known in the semiconductor arts is used. The to-be-formed islands 16 of active semiconductor material are covered by oxide 12, a nitride layer (not shown) and photoresist which protects these islands from the etch.

Folowing the formation of grooves 13—1 through 13—6, the structure is thermally oxidized in a well-known manner to form a thin oxide layer 14 of approximately 1000—2000 angstroms over the surfaces of the grooves. Other oxide thicknesses can be employed if desired. The resulting structure is shown in Figure 1c.

After thermal oxide layer 14 is formed on wafer 10, the binary glass 15 of this invention is deposited over the top surface of this structure to both fill grooves 13—1 through 13—6 and to form additional glass 15 on top of islands 16—1 through 16—5. This structure is illustrated schematically in Figure 1d. In accordance with this invention the binary glass comprises a mixture of oxide of germanium and of oxide of silicon and typically comprises a binary $GeO_2$—$SiO_2$ glass co-deposited using chemical vapor deposition at a temperature of 350°C to 500°C from a silanegermane source in an oxygen environment. This glass is formed to a selected thickness, typically approximately 1—3 microns.

Following the deposition of glass 15, the structure is heated to a temperature in the range of 650°C to 1000°C. The glass melts and flows into the grooves 13-1 through 13—6 to yield a structure as shown in Figure 1e wherein glass 15 fills grooves 13—1 through 13—6 to provide a substantially flat top surface 15a. Because the glass melts at less than 950°C, the dopants in the islands 16—1 through 16—5 are not substantialy affected by this heating and glass flow step and the electrical characteristics of the device remain unaltered when the glass is melted and flowed below this temperature. Actually, the structure can be heated to 1000°C for short periods of time less than ten (10) minutes because at 1000°C the dopants only begin to move after about ten (10) minutes.

Figure 2 illustrates a portion of the structure shown in cross-section in Figure 1e wherein additional interconnects 17a, 17b, 17c have been formed over the reflowed glass filling grooves 11—4, 11—5 and 11—6. Interconnect 17b contacts an active region formed in island 16—4 through via 18b opened through oxide layers 12 and 14 and connects this active region to an active region formed in island 16—5 through via 18c opened through oxide layers 12 and 14. Interconnect 17c connects an active region formed within island 16—5 contacted through opening 18d in oxide layers 12 and 14 to another active region or a contact pad. Interconnect 17a connects an active region formed in island 16—4 and contacted through via 18a to another active region formed in another island or to a contact pad.

In one embodiment, wafer 10 comprises a substrate 11 of silicon material processed in a standard manner to form active devices within selected regions 16—1 through 16—5 (Figure 1a) of the structure. Oxide layer 12 is formed on the top surface of wafer 10 in a standard, well-known manner. A layer of silicon nitride (not shown) is formed over oxide layer 12 in a standard well-known manner and is used to mask and thus protect those regions of silicon material 16—1 through 16—5 in which are formed active regions. Grooves are then etched using a standard silicon etch comprising, for example, a mixture of hydrofluoric, acetic, and nitric acid and then the resulting grooved silicon is further oxidized to form oxide layer 14 using well-known oxidation techniques. Oxide layer 14 is formed typically at a temperature of 900°C, sufficiently below the temperature at which diffusion takes place to prevent substantial change in the electrical properties of the active devices formed in islands 16—1 through 16—5. The binary glass of this invention is then formed as described above the top surface of the device and the structure is heated to a temperature of about 950°C to melt and reflow this binary glass so as to form a substantially flat top surface. Vias 18a through 18c are opened in the top surface of the oxide layers 12 and 14 and glass 15 in a standard well-known manner using photoresist masking techniques and a selected etchant (such as buffered hydrofluoric acid) and then interconnect lead structures are formed in a well-known manner over the top surface of the device from a selected conductive material, typically aluminum.

This invention has been described in conjunction with one embodiment. It will be apparent to those skilled in the art that other embodiments of this invention and other materials will be suitable for use in accordance with the invention.

**Claims**

1. The method of formimg an isolated semiconductor structure comprising:

forming active devices or selected components in to-be-formed islands (16) of semiconductor material, each island being separated from adjacent islands by an annular shaped band (11) of semiconductor material in which are formed no active devices or selected components, said active devices or selected components being formed by placing selected dopants in said to-be-formed islands (16) to form selectively doped regions in said islands;

etching grooves (13) in the surface of the semiconductor material so as to remove a portion of each annular shaped band in which no active devices were formed, thereby to create a plurality of islands of semicondictor material, each island containing active devices or selected components; oxidizing the semiconductor material exposed by said grooves to form an oxide layer (14) of selected thickness over the surface of said grooves; characterized by

depositing a binary glass (15) comprising a mixture of oxide of germanium and an oxide of silicon over the top surface of said device, said glass having the property that it melts and flows at a temperature beneath that temperature at which said dopants in the islands of semiconductor material substantially redistribute;

and heating the resulting structure to flow said glass to form a substantially flat surface (15a) over the top of said device.

2. The method of Claim 1 characterized in that said step of depositing said binary glass (15) comprises depositing a binary $GeO_2/SiO_2$ glass using chemical vapor deposition at a temperature in the range of 350°C to 500°C from a silane/ germane source in an oxygen environment.

3. The method of Claim 1 or 2 characterized in that said binary glass (15) is formed to a selected thickness between approximately 1—3 microns.

4. The method of any one of Claims 1—3 characterized in that said step of heating the resulting structure to flow said glass (15) comprises heating said resulting structure to a temperature in the range of 650°C to 1000°C.

5. The method of Claim 4 characterized in that said step of heating the resulting structure comprises the step of heating said resulting structure to a temperature of less than 950°C to flow said glass (15) to form a substantially flat surface (15a) over the top of said device.

6. The method of any previous claim characterized in that said semiconductor material comprises silicon.

7. The method of any previous claim characterized in that said step of etching grooves (13) in the surface of the semiconductor material comprises etching grooves using a mixture of hydrofluoric, acetic and nitric acid thereby to remove a portion of each annular shaped band in which no active device is formed, thereby to create a plurality of islands (16) of semiconductor material, each island containing active devices or selected components.

8. The method of any previous claim characterized by the additional step of forming on the substantially flat surface over the top of said device a plurality of openings through the selected glass and through said iunderlying oxide material and forming a selected interconnect pattern of conductive material over the top surface of said device so as to interconnect selected ones of said active devices or selected components.

9. An integrated circuit structure comprising:

a plurality of islands (16) of semiconductor material, each island being separated from adjacent islands of semiconductor material by a groove (13) formed in an annular shape around said island, each island containing active devices or selected components of the to-be-formed circuit formed by placing selected dopants in regions of each island;

grooves (13) formed in the surface of the semiconductor material in annular shape around each such island, thereby to laterally define the dimensions of each such island;

an oxide (14) formed over the surface of said grooves (13) and said islands (16) of semiconductor material; characterized by:

a binary glass (15) comprising a mixture of oxide of germanium and an oxide of silicon deposited on said oxide (14) in the grooves and over the top surface of said device, said glass having the property that it melts and flows at a temperature beneath the temperature at which the dopants in the islands of semiconductor material substantially redistribute, said selected glass having a substantially flat top surface (15a) thereby to give said structure a substantially flat top surface.

10. Structure as in Claim 9 characterized in that said structure includes vias formed through said glass and said oxide to contact selected ones of said active devices and components formed in said islands (16) of semiconductor material and conductive interconnect material formed in a selected pattern on the top surface of said glass (15) to contact selected ones of said active regions or selected components through said vias, thereby to interconnect selected ones of said active devices or selected components into a circuit.

**Patentansprüche**

1. Das Verfahren zur Bildung einer isolierten Halbleiterstruktur, umfassend:

Bilden aktiver Anordnungen oder ausgewählter Komponenten in zu bildenden Inseln (16) von Halbleitermaterial, wobei jede Insel von benachbarten Inseln durch ein ringartig geformtes Band (11) aus Halbleitermaterial getrennt ist, in dem keine aktiven Anordnungen oder ausgewählten Komponenten gebildet werden, wobei die genannten aktiven Anordnungen oder ausgewählten Komponenten gebildet werden durch Plazieren ausgewählter Dotierungsmittel in den genannten zu bildenden Inseln (16) zwecks Bildung ausgewählt dotierter Bereiche in den genannten Inseln;

Ätzen von Nuten (13) in die Oberfläche des Halbleitermaterial so, daß ein Abschnitt jedes ringartig geformten Bandes, in dem keine aktiven Anordnungen gebildet waren, abgetragen wird, um so eine Mehrzahl von Inseln von Halbleitermaterial zu erzeugen, wobei jede Insel aktive Anordnungen oder ausgewählte Komponenten enthält; Oxidieren des Halbleitermaterials, das durch die genannten Nuten exponiert ist, zur Bildung einer Oxidschicht (14) ausgewählter Dikke über der Oberfläche der genannten Nuten, gekennzeichnet durch

Ablagern eines binären Glases (15), umfassend ein Gemisch von Germaniumoxid und Siliciumoxid, über der oberen Oberfläche der genannten Anordnung, wobei das genannte Glas die Eigenschaft hat, daß es bei einer Temperatur unterhalb derjenigen Temperatur schmilzt und fließt, bei der die genannten Dotierungsmittel in den Inseln des Halbleitermaterials einer merkbaren Redistribution unterliegen, und Erwärmen der resultierenden Struktur zum Fließenlassen des genannten Glases zur Bildung einer im wesentlichen flachen Oberfläche (15a) über der Oberseite der genannten Anordnung.

2. Das Verfahren nach Anspruch 1, dadurch gekennzeichnet, daß der genannte Schritt der Anlagerung des genannten binären Glases (15) das Anlagern eines binären $GeO_2/SiO_2$-Glases umfaßt unter Verwendung chemischen Dampfniederschlags bei einer Temperatur im Bereich von 350°C bis 500°C aus einer Silan/Germaniumhydrid-Quelle in einer Sauerstoffumgebung.

3. Das Verfahren nach Anspruch 1 oder 2, dadurch gekennzeichnet, daß das genannte binäre Glas (15) mit einer ausgewählten Dicke zwischen etwa 1—3 Micron gebildet wird.

4. Das Verfahren nach einem der Ansprüche 1 bis 3, dadurch gekennzeichnet, daß der genannte Schritt der Erwärmung der resultierenden Struktur zum Fließenlassen des genannten Glases (15) das Erhitzen der genannten resultierenden Struktur auf eine Temperatur im Bereich von 650°C bis 1000°C umfaßt.

5. Das Verfahren nach Anspruch 4, dadurch gekennzeichnet, daß der genannte Schritt der Erwärmung der resultierenden Struktur den Schritt des Erhitzens der resultierenden Struktur auf eine Temperatur von weniger als 950°C zum Fließenlassen des genannten Glases (15) umfaßt zur Bildung einer im wesentlichen flachen Oberfläche (15a) über der Oberseite der genannten Anordnung.

6. Das Verfahren nach einem der vorangehenden Ansprüche, dadurch gekennzeichnet, daß das Halbleitermaterial Silicium umfaßt.

7. Das Verfahren nach einem der vorangehenden Ansprüche, dadurch gekennzeichnet, daß der genannte Schritt des Ätzens von Nuten (13) in die Oberfläche des Halbleitermaterials das Ätzen von Nuten unter Verwendung eines Gemisches von Fluß-, Essig- und Salpetersäure umfaßt, derart, daß ein Abschnitt jedes ringartig geformten Bandes abgetragen wird, in welchem keine aktive Anordnung gebildet wird, und wobei eine Mehrzahl von Inseln (16) von Halbleitermaterial erzeugt wird, von denen jede Insel aktive Anordnungen oder ausgewählte Komponenten enthält.

8. Das Verfahren nach einem der vorangehenden Ansprüche, gekennzeichnet, durch den zusätzlichen Schritt der Bildung einer Mehrzahl von Öffnungen auf der im wesentlichen flachen Oberfläche über der Oberseite der genannten Anordnung durch das ausgewählte Glas und durch das genannte darunterliegende Oxidmaterial und Bildung eines ausgewählten Verbindungsmusters von leitendem Material über der oberen Oberfläche der genannten Anordnung, um so ausgewählte der aktiven Anordnungen oder ausgewählten Komponenten miteinander zu verbinden.

9. Integrierte Schaltkreisstruktur, umfassend:

eine Mehrzahl von Inseln (16) aus Halbleitermaterial, wobei jede Insel von benachbarten Inseln von Halbleitermaterial durch eine Nut (13) getrennt ist, gebildet in einer Ringform rings um die genannte Insel, wobei jede Insel aktive Anordnungen oder ausgewählte Komponenten des zu bildenden Schaltkreises enthält, gebildet durch Plazieren ausgewählter Dotierungsmittel in Bereichen jeder Insel,

Nuten (13), gebildet in der Oberfläche des Halbleitermaterials in Ringform rings um jede solche Insel derart, daß seitlich die Abmessungen jeder solchen Insel begrenzt werden,

ein Oxid (14), gebildet über der Oberfläche der genannten Nuten (13) und der genannten Inseln (16) von Halbleitermaterial, gekennzeichnet durch

ein binäres Glas (15), umfassend ein Gemisch von Germaniumoxid und einem Siliciumoxid, niedergeschlagen auf dem genannten Oxid (14) in den Nuten und über der oberen Oberfläche der genannten Anordnung, welches Glas die Eigenschaft besitzt, daß es bei einer Temperatur schmilzt und fließt, die unterhalb der Temperatur liegt, bei der die Dotierungsmittel in den Inseln aus Halbleitermaterial einer merkbaren Redistribution unterliegen, wobei das genannte ausgewählte Glas eine im wesentlichen flache obere Oberfläche (15a) aufweist, derart, daß es der genannten Struktur eine im wesentlichen flache obere Oberfläche verleiht.

10. Struktur nach Anspruch 9, dadurch gekennzeichnet, daß die Struktur Durchlässe umfaßt, gebildet durch das Glas und das genannte Oxid zum Kontaktieren ausgewählter der genannten aktiven Anordnungen und Komponenten, gebildet in den genannten Inseln (16) von Halbleitermaterial, sowie leitendes Verbindungsmaterial, gebildet in einem ausgewählten Muster auf der oberen Oberfläche des genannten Glases (15) zum Kontaktieren ausgewählter der genannten aktiven Bereiche oder ausgewählten Komponenten durch die genannten Durchlässe, derart, daß ausgewählte der genannten aktiven Anordnungen oder ausgewählten Komponenten in eine Schaltung miteinander verbunden werden.

**Revendications**

1. Procédé de réalisation d'une structure semiconductrice isolée comprenant les étapes suivantes:

réaliser des dispositifs actifs ou des composants sélectionnés dans de futurs îlots (16) de matériau semi-conducteur, chaque îlot étant séparé des îlots voisins par une bande annulaire (11) de matériau semi-conducteur dans laquelle n'est réalisé ni dispositif actif, ni composant sélectionné, lesdits dispositifs actifs ou composants sélectionnés étant réalisés en disposant des dopants sélectionnés dans lesdits futurs îlots (16) pour former des régions sélectivement dopées dans lesdits îlots;

découper des gorges (13) dans la surface du matériau semi-conducteur pour supprimer une partie de chaque bande annulaire dans laquelle aucun dispositif actif n'est réalisé, de façon à créer une pluralité d'îlots de matériau semi-conducteur, chaque îlot contenant des dispositifs actifs ou des composants sélectionnés:

oxyder le matériau semi-conducteur exposé par lesdites gorges pour former une couche d'oxyde (14) d'épaisseur sélectionnée sur la surface desdites gorges; caractérisé par les étapes suivantes:

déposer sur la surface supérieure du dispositif un verre binaire (15) comprenant un mélange d'oxyde de germanium et d'oxyde de silicium, ledit verre ayant la propriété de fonde et de couler à une température inférieure à celle pour laquelle lesdits dopants se redistribuent sensiblement dans les îlots de matériau semi-conducteur; et

chauffer la structure résultante pour faire fondre leditt verre afin de réaliser une surface (15a) sensiblement plate sur le sommet dudit dispositif.

2. Procédé selon la revendication 1, caractérisé en ce que ladite étape de dépôt dudit verre binaire (15) comprend l'opération consistant à déposer un verre binaire $GeO_2/SiO_2$ par un dépôt chimique en phase vapeur à une température de 350°C à 500°C à partir d'une source de silane/germane dans un environnement d'oxygène.

3. Procédé selon la revendication 1 ou 2, caractérisé en ce que ledit verre binaire (15) est réalisé avec une épaisseur sélectionnée comprise approximativement entre 1 et 3 microns.

4. Procédé selon l'une des revendications 1 à 3, caractérisé en ce que ladite étape de chauffage de la structure résultante pour faire fondre ledit verre (15) comprend l'opération consistant à chauffer ladite structure résultante à une température située dans une plage allant de 650°C à 1000°C.

5. Procédé selon la revendication 4, caractérisé en ce que ladite étape de chauffage de la structure résultante comprend l'opération consistant à chauffer la structure résultante à une température inférieure à 980°C pour faire fondre ledit verre (15) afin de réaliser une surface (15a) sensiblement plate sur le sommet dudit dispositif.

6. Procédé selon l'une des revendications précédentes, caractérisé en ce que ledit matériau semi-conducteur est du silicium.

7. Procédé selon l'une des revendications précédentes, caractérisé en ce que ladite étape de découpage des gorges (13) dans la surface du matériau semi-conducteur comprend l'opération de découper des gorges en attaquant par un mélange d'acide fluorhydrique, acétique et nitrique afin de supprimer une partie de chaque bande annulaire dans laquelle aucun dispositif actif n'est réalisé, afin de créer une pluralité d'îlots (16) de matériau semi-conducteur, chaque îlot contenant des dispositifs actifs ou des composants sélectionnés.

8. Procédé selon l'une des revendications précédentés, caractérisé par l'étape supplémentaire consistant à réaliser sur la surface sensiblement plate du sommet de chaque dispositif une pluralité d'ouvertures au travers du verre sélectionné et au travers de l'oxyde sous-jacent et à réaliser un motif d'interconnexion sélectionné de matériau conducteur sur la surface supérieure dudit dispositif de façon à interconnecter certains des dispositifs actifs ou des composants sélectionnés.

9. Structure de circuit intégré comprenant:

une pluralité d'îlots (16) de matériau semi-conducteur, chaque îlot étant séparé des îlots voisins de matériau semi-conducteur par une gorge (13) réalisée sous forme annulaire autour dudit îlot, chaque îlot contenant des dispositifs actifs ou des composants sélectionnés du futur circuit réalisés en plaçant des dopants sélectionnés dans des régions de chaque îlot;

des gorges (13) réalisées dans la surface du matériau semi-conducteur sous forme annulaire autour de chaque îlot, définissant ainsi latéralement les dimensions de chacun desdits îlots;

un oxyde (14) réalisé sur la surface desdites gorges (13) et desdits îlots (16) de matériau semi-conducteur; caractérisé par:

un verre binaire (15) comprenant un mélange d'oxyde de germanium et d'oxyde de silicium déposé sur ledit oxyde (14) dans les gorges et sur la surface supérieure dudit dispositif, ledit verre ayant la propriété de fondre et de couler à une température inférieure à celle pour laquelle les dopants se redistribuent sensiblement dans les îlots de matériau semi-conducteur, ledit verre sélectionné ayant une surface supérieure (15a) sensiblement plate de façon à donner à ladite structure une surface supérieure sensiblement plate.

10. Structure selon la revendication 9, caractérisée en ce que ladite structure comprend des voies traversant ledit verre et ledit oxyde pour venir en contact sur des éléments sélectionnés parmi les dispositifs actifs et les composants réalisés dans lesdits îlots (16) de matériau semi-conducteur et un matériau conducteur d'interconnexion réalisé suivant un motif sélectionné sur la surface supérieure dudit verre (15) pour venir en contact, par l'intermédiaire desdites voies, sur des éléments sélectionnés parmi lesdits éléments actifs ou les composants sélectionnés de façon à interconnecter des éléments sélectionnés parmi lesdits dispositifs actifs ou les composants sélectionnés pour former un circuit.

FIG. Ia

FIG. Ib

FIG. Ic

FIG. Id

FIG. Ie

FIG. 2